# EUROPÄISCHE PATENTSCHRIFT

(11) **EP 1 913 643 B1**
(45) Veröffentlichungstag und Bekanntmachung des Hinweises auf die Patenterteilung: **04.07.2012**
(21) Anmeldenummer: 06776488.6
(22) Anmeldetag: 28.07.2006
(51) Int. Cl.: H01L 31/04

(54) **SOLARZELLENMODUL UND VERFAHREN ZU SEINER HERSTELLUNG**
SOLAR CELL MODULE AND METHOD FOR ITS PRODUCTION
MODULE DE CELLULES SOLAIRES ET SON PROCEDE DE PRODUCTION

(30) Priorität: 29.07.2005 DE 102005035672
(43) Veröffentlichungstag der Anmeldung: 23.04.2008
(73) Patentinhaber: Fraunhofer-Gesellschaft zur Förderung der angewandten Forschung e.V., 80686 München (DE)
(72) Erfinder: JAUS, Joachim, 79098 Freiburg (DE); BETT, Andreas, 79114 Freiburg (DE); BÖSCH, Armin, 79285 Ebringen (DE); DIMROTH, Frank, 79115 Freiburg (DE); LERCHENMÜLLER, Hansjörg, 79100 Freiburg (DE)
(74) Vertreter: Pfenning, Meinig & Partner GbR
(86) Internationale Anmeldenummer: PCT/EP2006/007500
(87) Internationale Veröffentlichungsnummer: WO 2007/014716

(56) Entgegenhaltungen:
- EP-A2- 0 657 948
- WO-A-91/18419
- US-A- 4 834 805
- US-A- 4 836 861

## Beschreibung

Die vorliegende Erfindung betrifft ein Solarzellenmodul sowie ein Verfahren zu seiner Herstellung. Derartige Solarzellenmodule werden insbesondere im Bereich der konzentrierenden Solartechnik verwendet.

In der Photovoltaik werden mehrere Solarzellen zu größeren Modulen zusammengefasst. Innerhalb eines Moduls sind mehrere Solarzellen miteinander verschaltet, das Modul übernimmt außerdem weitere Aufgaben wie z.B. den Schutz vor Witterungseinflüssen der meist sehr empfindlichen Zellen.

Ein Spezialgebiet der Photovoltaik ist die sogenannte "Konzentrator-Photovoltaik", bei der durch ein optisches System (z.B. Linse, Spiegel) das Sonnenlicht konzentriert wird und der konzentrierte Lichtstrahl auf eine - je nach Anlagenart - relativ kleine Solarzelle trifft.

Dazu muss die Zelle exakt im Fokus der Linse positioniert sein. Durch die geringe Größe der Zellen werden häufig spezielle Kontaktierungsverfahren (z.B. Bonding) notwendig, um die Zellen zu kontaktieren. Diese Verfahren sind jedoch häufig nicht geeignet, auch die verschiedenen Zellen im Modul zu verschalten. Hierzu sind dann weitere Kontaktierungsschritte notwendig.

In einer Konzentrator-Photovoltaik wird durch Linsen Solarstrahlung gebündelt. Dadurch werden auf sehr kleinen Flächen sehr hohe Energiedichten erreicht. So wird z.B. auf einem Kreis von 2 mm Durchmesser die 500-fache Sonnenenergie erzielt. Die Strahlungsverteilung hat hierbei eine gauss-förmige Verteilung, wodurch im Mittelpunkt des Brennflecks (ein Bereich von ca. 0,3 mm Durchmesser) eine über 2000-fach konzentrierte Sonnenstrahlung auftritt. Daher muss die Solarzelle im direkten Kontakt mit einer Wärmesenke montiert werden. Um die Bildung von Hotspots zu verhindern, ist die wichtigste Aufgabe dieser Wärmesenke zunächst die Verteilung der entsprechenden Verlustenergie in lateraler Richtung, d.h. in die Breite sowie gleichzeitig natürlich auch eine Übertragung zu den darunterliegenden Schichten. Um dies zu erreichen, wird daher im Stand der Technik die Rückseite der Solarzelle mit einer metallischen Schicht verbunden. Außerdem muss die Oberseite der Solarzelle als zweite elektrischer Pol kontaktiert werden. Dabei wird diese Kontaktierung mittels derselben metallischen Schicht vorgenommen, die auch die Kontaktierung der Solarzellenunterseite realisiert. Diese Schicht muss daher in verschiedene elektrisch (und daher auch mechanisch und thermisch) getrennte Bereiche strukturiert werden. Dies geschieht durch das Abtragen von Kupfer in bestimmten Bereichen, so dass voneinander elektrisch isolierte Bereiche entstehen.

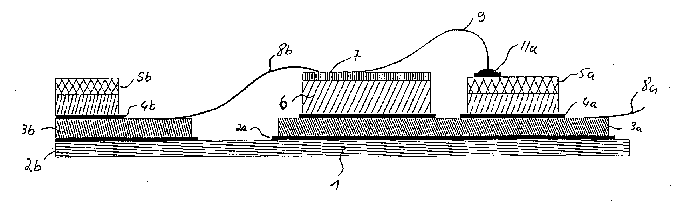

Figur 1 zeigt eine Solarzelle nach dem Stand der Technik. Diese weist ein Substrat (Modulboden, Glasträger) 1 auf, auf dem mittels einer Klebeschicht 2a eine Kupferplatte 3a aufgebracht ist. Auf dieser Kupferplatte ist mittels einer elektrisch leitfähigen Klebeschicht 4a eine Solarzelle 5a platziert. Durch die elektrisch leitfähige Kontaktierung der Solarzelle 5a mit der Kupferplatte 3a wird die Solarzelle an ihrem Rückseitenkontakt, hier ihrem Pluspol, kontaktiert. Seitlich versetzt zu der Solarzelle 5a ist eine Isolationsschicht 6 angeordnet, die beispielsweise aus einem Glasfaserverbundwerkstoff bestehen kann. Diese Isolationsschicht 6 weist auf ihrer dem Substrat 1 abgewandten Seite eine elektrisch leitfähige Goldschicht 7 auf. Die Goldschicht 7 ist über einen Bonddraht 9 elektrisch mit einem Kontakt 11a als Minuspol der Solarzelle verschaltet.

In Figur 1 ist neben der bisher beschriebenen Anordnung einer Solarzelle seitlich versetzt auf dem Substrat eine zweite Solarzelle 5b in entsprechender Weise angeordnet. Zur seriellen Verschaltung der beiden Solarzellen 5a und 5b wird die Goldschicht 7 mit der Kupferschicht 3b der Solarzelle 5b elektrisch über eine Verbindung 8b verbunden.

Zur Herstellung einer derartigen Solarzelle werden nun einzelne bestückte Kupferplättchen 3a, 3b (sog. Solarzellenchips) einzeln auf die Bodenplatte 1 über eine Klebeverbindung 2a montiert. Dabei muss die Solarzelle 5a bzw. 5b jeweils exakt platziert werden, so dass sich das Zentrum der Solarzelle im Brennpunkt der darüber angebrachten Linse befindet. Die elektrische Verbindung 8b zwischen den einzelnen Zellen erfolgt erst danach durch Anlöten z.B. eines Silberbändchens 8b. Nachteilig hieran ist, dass eine große Zahl einzelner Teile notwendig ist, für die Kosten bei der Beschaffung sowie bei der Lagerung und Fertigungslogistik entstehen. Es fallen während der Montage vielerlei Arbeitsschritte an, wie beispielsweise die Vorbereitung der einzelnen Oberflächen, das Auftragen von Verbindungsmaterialien, wie Kleber und Lot, das Greifen und Positionieren der einzelnen Teile, Aushärten der Klebeschichten sowie diverse Lötprozesse. Hierzu kommen noch weitere prozessbegleitende Schritte. Diese große Anzahl von Arbeitsschritten erhöht die Taktzeiten und erniedrigt den Durchsatz einer Fertigungslinie für Solarzellenmodule in der Konzentrator-Photovoltaik. Auch der Materialaufwand ist sehr hoch und verursacht hohe Kosten.

Insbesondere sind einige Schritte der Herstellung des Solarmoduls besonders kostenträchtig, wie beispielsweise die Lötprozesse. Die Materialkosten für beispielsweise die Silberbändchen 8b sind ebenfalls sehr hoch.

In US 4,834,805 wird ein photovoltaisches Konzentratormodul mit kleinen Abmessungen beschrieben, wobei die Solarzellen in einer Matrix auf einem Substrat angeordnet sind, welches ein Paar von Dünnschichtleitern, die durch eine Isolierschicht getrennt sind, aufweist.

Aufgabe der vorliegenden Erfindung ist es daher, ein Solarzellenmodul sowie ein Verfahren zu seiner Herstellung zu schaffen, mit dem Solarzellen fertigungstechnisch günstig und kostengünstig und in präziser Weise hergestellt werden können, wobei eine hervorragende Wärmeableitung gewährleistet werden soll.

Diese Aufgabe wird durch das Solarzellenmodul durch Anspruch 1 sowie das Verfahren nach Anspruch 23 gelöst. Vorteilhafte Weiterbildung des erfindungsgemäßen Solarzellenmoduls und des erfindungsgemäßen Verfahrens werden in den jeweiligen abhängigen Ansprüchen gegeben.

Entscheidend bei der vorliegenden Erfindung ist es nun, dass während der Herstellung des Moduls nicht zuerst einzelne voll kontaktierte Solarzellenchips gefertigt und anschließend einzeln positioniert werden, sondern in einem Arbeitsschritt die gesamte Modulfläche mit einer Metallschicht, beispielsweise einer Kupferschicht, versehen wird, die zum einen die Kontaktierung der Solarzellen sowohl bezüglich des Minus- als auch des Pluspols bewerkstelligt und obendrein die Positionierung der Solarzellen selbst erleichtert. Hierzu wird ein flächiges, dünnes, beispielsweise 0,01 bis 3 mm dickes Metallsubstrat, beispielsweise ein Kupferfolie, durch ein geeignetes Verfahren, wie beispielsweise Stanzen oder Laserstrahlschneiden, strukturiert. Diese strukturierte Metallfläche kann dann mit dem Modulboden (Substrat) verbunden werden. Es ist auch möglich, zuerst eine Metallschicht auf dem Modulboden aufzubringen und so ein Laminat, beispielsweise eine auf Glas laminierte Metallfolie, herzustellen. Die Strukturierung kann dann anschließend unmittelbar auf dem Substrat erfolgen. Die Strukturierung selbst ist durch sämtliche herkömmlichen Maßnahmen, wie beispielsweise Ätzverfahren oder auch Laserbearbeitung möglich.

Als Metalle für die Metallschicht bzw. die Metallfolie eignen sich vorteilhafterweise alle Metalle, die für Wärmeleitfolien verwendet werden, insbesondere Kupfer, Aluminium und/oder Legierungen hiervon.

Mit einem Solarmodul gemäß der vorliegenden Erfindung ist die elektrische Kontaktierung der Solarzellen sowie die elektrische Verschaltung der einzelnen Solarzellen innerhalb des Moduls sichergestellt. Außerdem wird die Solarzelle dauerhaft an einem vorbestimmten Ort innerhalb des Moduls exakt positioniert, so dass diese immer im Brennpunkt der konzentrierenden Optik positioniert ist. Durch die große wärmeleitende Metallfläche wird weiterhin die in den Solarzellen anfallende Wärme sehr gut abgeführt, so dass eine Überhitzung der Solarzellen vermieden werden kann. Mit der Struktur der vorliegenden Erfindung können beispielsweise mit nur einer auf einem Glasträger als Substrat auflaminierten, sehr dünnen Kupferschicht (mit einer Dicke gemäß Anspruch 10, beispielsweise von lediglich 70 *µ*m bis 500 *µ*m), die folgenden Funktionen gleichzeitig erfüllt werden:
1. Mechanische Fixierung der Zelle
2. Elektrische Kontaktierung der einzelnen Zellen
3. Elektrische Verschaltung der Zellen untereinander
4. Wärmeableitung bis zur Außenluft

Die Metallfläche kann weiterhin so strukturiert sein, dass Kräfte, die durch die Wärmeausdehnung der verschiedenen Materialien von Substrat, Metall und Solarzelle innerhalb des Moduls auftreten, aufgenommen und ggf. auch kompensiert werden. Durch die Metallfläche ist es weiterhin möglich, verschiedene elektrische Schutzeinrichtungen und Zusatzfunktionen, d.h. elektrische Schaltungen, gleich während der Fertigung mitzuintegrieren.

Durch dieses besondere Vorgehen bei der Herstellung des Solarmoduls verringert sich der Logistikaufwand in der Arbeitsvorbereitung, Lagerhaltung und Montage erheblich. Der Materialeinsatz wird ebenfalls verringert, so dass insgesamt ein geringerer maschineller, personeller und finanzieller Aufwand erforderlich ist.

Durch die vorliegende Erfindung ist es weiterhin erstmals möglich geworden, die bereits in der Elektronikindustrie standardmäßig verwendeten Leiterplattentechnologien, Laminationstechnologie und Lead-Frame-Technologie zur Herstellung von Solarmodulen einzusetzen. Die Bestückung eines erfindungsgemäßen Solarmoduls mit Solarzellen, Schutzschaltungen und dergleichen kann daher nun mit Standardtechnologie realisiert werden.

Durch den Einsatz von Justiermarken, die in die Metallfläche einstrukturiert sind, ist es weiterhin möglich, die Positionierung von Solarzellen und anderen elektronischen Bauteilen weiter zu standardisieren und zu präzisieren.

Da die Position der einzelnen Solarzellen auf der Metallfläche bzw. Metallfolie relativ zueinander durch die durchgehende Metallfläche fixiert ist, benötigt man lediglich noch einen einzigen Justageschritt, um die konzentrierende Optik, beispielsweise einen Kollimatorlinsenarray, bezüglich der Solarzellen zu positionieren.

Das erfindungsgemäße Solarzellenmodul weist vorteilhafterweise eine Vielzahl weiterer Merkmale auf, die im folgenden aufgezählt werden:
● An den Stellen; an denen sich der Brennpunkt des konzentrierenden optischen Systems ausbildet, befindet sich der vorgesehene Platz zur Aufnahme der Solarzelle.
● An diesen Stellen wird beim Bestückungsvorgang mit hoher Genauigkeit die Solarzelle platziert und der Rückseitkontakt (Pluspol oder Minuspol) der Solarzelle elektrisch mit dem Metallsubstrat verbunden.
● Zur einfacheren Positionierung der Zelle kann die Strukturierung des Metallsubstrats die Ausbildung von Positioniermarken beinhalten.
● Zur Ableitung des Stroms von der Oberfläche (Minuspol) der Solarzelle weist das Metallsubstrat pro Zelle einen oder mehrere Kontaktfinger aus, die in der Nähe des Chips enden.
● Die Kontaktfinger werden idealerweise radial und/oder als sehr schmale Leiterbahnen zur Zelle hingeführt, um die Wärmeableitung vom Zellmittelpunkt so wenig wie möglich zu stören. Vorteilhafterweise verjüngen sich die Kontaktfläche zur Solarzelle hin, um zum einen maximale Stabilität und elektrische Leitfähigkeit zu erzielen und zum anderen unmittelbar bei der Solarzelle die laterale Wärmeabfuhr so wenig wie möglich zu behindern, das heißt Platz für einen breiten Rückseitenkontakt der Solarzelle freizuhalten.
● Die Kontaktfinger können in einem bestimmten Abstand zur Zelle enden. Dadurch ist es möglich, den Bonddraht ausreichend kurz zu halten, jedoch auch zugleich nach Strukturierung des Metallsubstrates Variationen in der Lokalisation der Brennpunkte zu berücksichtigen und die Zelle entsprechend versetzt zu platzieren. Außerdem wird bei geeignetem Abstand die Wärmeübertragung verbessert, da mehr Fläche für den Rückseitenkontakt zur Verfügung steht.
● Die Spitzen der Kontaktfinger können lokal mit einem geeigneten Material beschichtet werden (Ausbildung sog. Pads), um eine bessere Kontaktierung durch Bonding zu ermöglichen. Hierzu eignet sich insbesondere eine partielle Vergoldung, z.B. aus einer 1 bis 6 *µ*m dicken Nickelschicht gefolgt von einer 0,5 bis 5 *µ*m dicken Goldschicht.
● Die Spitzen der Kontaktfinger werden durch einen dünnen Draht ("Drahtbonden") mit dem zweiten Kontakt, z.B. auf der Oberseite der Solarzelle, verbunden. Der zweite Kontakt ist dann gegenpolig zum ersten Kontakt bzw. Rückseitkontakt als Minuspol oder Pluspol der Solarzelle ausgebildet.
● Das Metallsubstrat weist Zonen auf, die direkt mit dem Minuspol der Solarzelle verbunden sind, und solche, die direkt mit dem Pluspol verbunden sind.
● Zur Realisierung einer Reihenschaltung sind jeweils gegensätzliche Zonen angrenzender Chips miteinander verbunden.
● Zur Realisierung einer Parallelschaltung sind gleiche Zonen angrenzender Chips miteinander verbunden.
● Je nach Anwendungszweck werden mehrere Zellen zusammengeschaltet. Bei entsprechender Größe der Metallfläche lassen sich alle Zellen eines Moduls auf einer Fläche realisieren, oder es lassen sich auch nur einzelne Zellen zu Blöcken zusammenfassen, die dann in herkömmlicher Weise miteinander verbunden werden.

Im folgenden werden nun einige Beispiele erfindungsgemäßer Solarzellenmodule gegeben. Dabei werden für gleiche und ähnliche Elemente, gleiche oder ähnliche Bezugszeichen verwendet.
- Figur 1: zeigt einen Ausschnitt eines herkömmlichen Solarzellenmoduls mit einem montierten Solarzellenchip;
- Figur 2: zeigt einen Ausschnitt aus einem erfindungsgemäßen Modul;
- Figur 3: zeigt einen weiteren vergrößerten Ausschnitt aus einem Solarzellenmodul gemäß Figur 2;
- Figuren 4: bis 6 zeigen den Aufbau weiterer Solarzellenmodule; und
- Figur 7: zeigt ein vollständiges Solarmodul mit Konzentratoroptik.

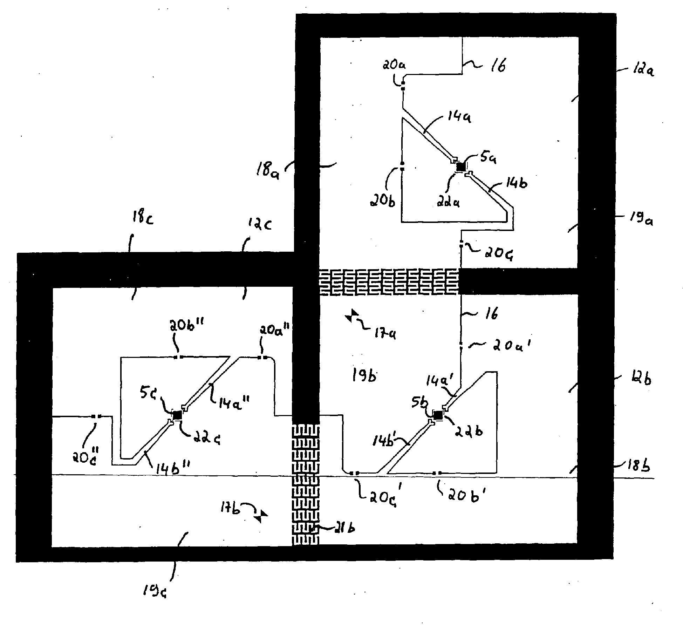

Figur 2 zeigt einen Ausschnitt aus einem Solarmodul gemäß der vorliegenden Erfindung. Bei der vorliegenden Erfindung handelt es sich um Solarzellenmodule für konzentrierende Solarsysteme. Hierbei wird das Sonnenlicht mit Hilfe einer Optik auf einen winzigen Brennfleck fokussiert, in dem sich dann lediglich noch eine kleine Solarzelle befindet. Die erfindungsgemäßen Solarzellenmodule bestehen nun aus einem flächigen, zweidimensionalen Array aus entsprechenden Konzentratoroptiken, die einen zweidimensionalen Array von Brennflecken erzeugen. In jedem Brennfleck wird nun eine Solarzelle angeordnet. Dies hat den Vorteil, dass bei der konzentrierenden Solartechnologie hocheffiziente Solarzellen eingesetzt werden können. So wird beispielsweise bei der sog. Flatcon™-Technologie ein Array von Fresnel-Linsen eingesetzt, die das Sonnenlicht um einen Faktor von 300 bis 1000 konzentrieren und auf einen kleinen Brennfleck fokussieren. In jedem Brennfleck jeder einzelnen FresnelLinse befindet sich dann eine 1 bis 10 mm² kleine Solarzelle. Damit kann insgesamt teure Halbleiterfläche hocheffizienter Solarzellen, beispielsweise von III-V-Stapelzellen durch eine vergleichsweise günstige Optik ersetzt werden. Außerdem steigt der Wirkungsgrad einer Solarzelle logarithmisch mit der Konzentration des Sonnenlichts, so dass die Konzentrator-Solartechnik höhere Effizienzen als herkömmliche Solartechnik ermöglicht.

In Figur 2 ist nun eine Aufsicht auf drei Elemente einer Anordnung von Solarzellen auf einem Substrat eines derartigen Solarzellenmoduls dargestellt. Dabei sind die schwarzen Flächen nicht-leitende Bereiche, während die weißen Flächen leitende Kupferschichten sind. Insbesondere ist die Kupferschicht mittels Gräben 16 strukturiert, so dass elektrisch voneinander isolierte Bereiche 18a bis 18c bzw. 19a bis 19c entstehen.

In der Mitte jedes Abschnitts 12a bis 12c ist jeweils eine Solarzelle 5a bis 5c angeordnet. Die Anordnung der Solarzelle erfolgt dabei innerhalb eines Justage- bzw. Ausgleichsbereichs 21a bis 21c. Wie zu erkennen ist, kontaktiert die Rückseite bzw. Unterseite der Solarzelle 5a im Abschnitt 12a (und wie im folgenden durchgängig auch die entsprechenden Solarzellen 5b und 5c in ihren jeweiligen Bereichen die entsprechenden Elemente) die Kupferfläche im Bereich 19a. Diese Fläche 19a stellt einen Pluspol dar. Die Fläche 19a kontaktiert dabei die Solarzelle 5a rückseitig sehr großflächig, so dass die in der Solarzelle 5a erzeugte Wärme hervorragend abgeführt und verteilt werden kann. Die Fläche 19a wird dabei lediglich durch zwei Kontaktfinger 14a, 14b verringert, die den Minuspol der Solarzelle 5a auf deren Oberfläche mittels eines hier nicht dargestellten Bonddrahtes kontaktieren. Über die Finger ist auch eine weitere Kontaktierung der Solarzelle möglich.

Wie in Figur 2 zu erkennen ist, sind die Gräben 16 durch Stanzmarken 20a, 20b, 20c unterbrochen, so dass während des Fertigungsprozesses hier noch eine mechanische Verbindung und damit auch elektrische Kontaktierung zwischen dem Minuspol 18a und dem Pluspol 19a vorliegt. Derartige Stanzmarken sind erforderlich, um eine über sämtliche Abschnitte 12a bis 12c mechanisch zusammenhängende Kupferfolie zu erhalten, die geschlossen an einem Stück auf ein Substrat aufgebracht werden kann. Nach Aufbringen der Kupferfolie werden dann die Stanzmarken 20a, 20b, 20c beispielsweise mittels eines Lasers durchtrennt, so dass eine elektrische Isolierung zwischen den Bereichen 18a und 19a erfolgt. Die Verwendung von Stanzmarken (Verbindungsstegen) ermöglicht es, die Kupferschicht bereits vor dem Aufbringen auf das Substrat zu strukturieren. Dadurch wird neben dem Strukturieren, z.B. Ätzen, von einer Seite der Kupferschicht auch ein Strukturieren von beiden Seiten möglich. Werden z.B. Trenngräben von beiden Seiten geätzt, so kann deren Breite erheblich geringer gehalten werden als beim Ätzen nur von einer Seite. Die Breite der Isolationsgräben kann damit verringert (z.B. halbiert) werden und damit auch die für die Wärmeabfuhr verbleibende Kupferschicht verbreitert werden.

Im vorliegenden Beispiel sind die Bereiche 19a, 18b und 19c elektrisch über mäanderförmige Strukturen 21a und 21b miteinander verbunden. In gleicher Weise sind die Bereiche 18a, 19b und 18c elektrisch miteinander verbunden. Dies bedeutet, dass der Pluspol 19a der Solarzelle über den Kontaktfinger 14a' mit dem Minuspol der Solarzelle 5b und der Pluspol der Solarzelle 5b über den Bereich 19b und den Kontaktfinger 14a'' mit dem Minuspol der Solarzelle 5c verbunden ist. Es handelt sich also um eine serielle Verschaltung der Solarzellen 5a, 5b und 5c.

Die mäanderförmigen Strukturen 21a und 21b trennen die einzelnen Abschnitte 12a, 12b und 12c voneinander und sorgen für einen mechanischen Ausgleich zwischen den einzelnen Abschnitten 12a bis 12c und damit für eine Kompensation unterschiedlicher Wärmeausdehnungen der einzelnen Abschnitte 12a, 12b und 12c.

Weiterhin ist in Figur 2 zu erkennen, dass in den Abschnitten 2b und 2c Positioniermarken 17a und 17b angeordnet sind, die eine präzise und automatische Bestückung der einzelnen Abschnitte 12a bis 12c mit den Solarzellen 5a bis 5c ermöglichen.

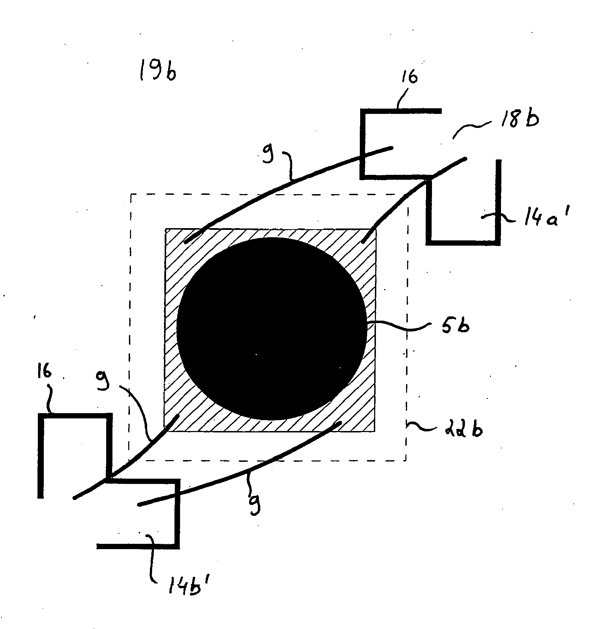

Figur 3 zeigt nun einen Ausschnitt aus dem Abschnitt 12b in Figur 2. Zu erkennen sind die der Solarzelle 5b zugewandten Enden der Finger 14a' und 14b'. Die Solarzelle 5b ist innerhalb eines markierten Justagebereichs 22b angeordnet und über Bonddrähte 9 mit den Fingern 14a' und 14b' verbunden.

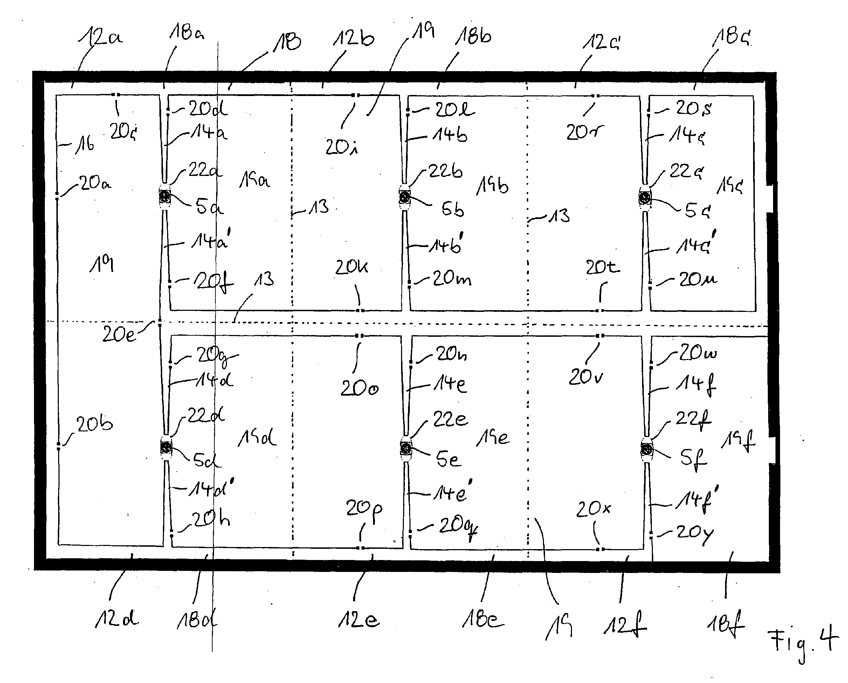

Figur 4 zeigt nun ein erfindungsgemäßes Solarzellenmodul, bei dem die Stanzmarken 20a bis 20y noch nicht durchbrochen wurden. Derartige Stanzmarken sind, wie bereits beschrieben, erforderlich, sofern die Folie vor dem Aufbringen auf das Substrat strukturiert wird. Wird die Folie erst in mit dem Substrat laminiertem Zustand strukturiert, sind derartige Stanzmarken nicht erforderlich.

In Figur 4 ist ein Modul bestehend aus einer Anordnung von 2 mal 3 Solarzellen 5a bis 5f dargestellt. Dieses Solarzellenmodul, dessen Kupferoberfläche dargestellt ist, ohne die oberhalb der Zeichnungsebene liegenden konzentrierenden Fresnel-Linsen darzustellen, ist folglich in sechs Abschnitte 12a bis 12f unterteilt, wobei die gestrichelten Trennungslinien 13 zwischen den Abschnitten 12a bis 12f lediglich dem besseren Verständnis der Erfindung in Figur 4 eingezeichnet wurden. Die gestrichelten Linien 13 sind auf dem realen Modul nicht zu erkennen.

Im vorliegenden Fall sind nun sämtliche Unterseiten der Solarzellen 5a bis 5f, d.h. sämtliche Pluspole miteinander über die Flächen 19a bis 19f, die eine einheitliche Fläche 19 bilden, verbunden. Die Flächen 18a bis 18f, die eine einheitliche Fläche 18 einschließlich der Finger 14a bis 14f' bilden, sind ebenfalls miteinander elektrisch leitend verbunden. Bei dem in Figur 4 vorliegenden Array handelt es sich also um eine Parallelschaltung der Solarzellen 5a bis 5f.

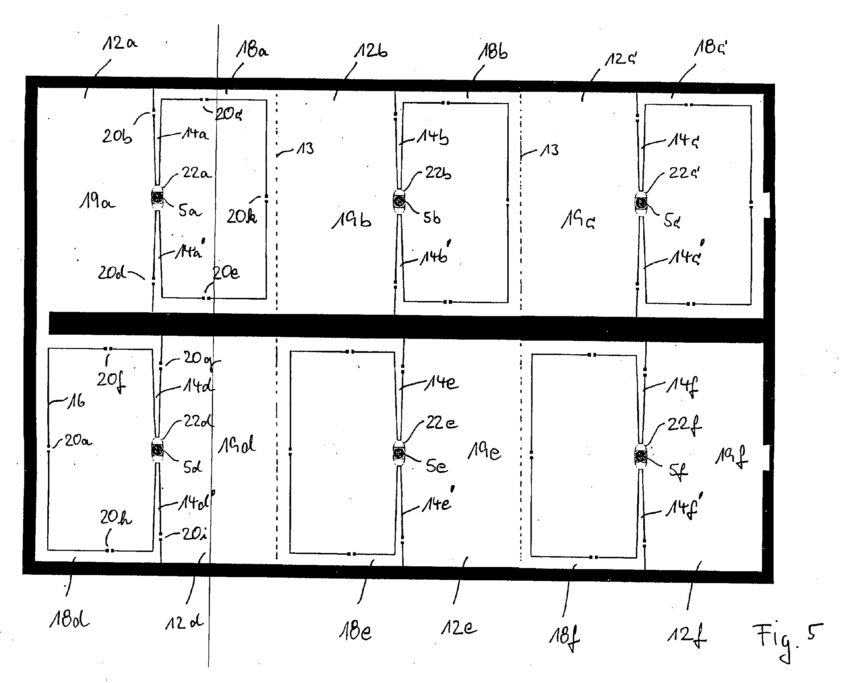

In Figur 5 ist ein der Figur 4 entsprechender Array von 2 mal 3 Solarzellen 5a bis 5f dargestellt, wobei jedoch nunmehr eine serielle Verschaltung realisiert ist. Auch hier sind die Linien 13 zur Unterteilung des Moduls in einzelne Abschnitte 12a bis 12f lediglich für das bessere Verständnis eingezeichnet. Hier wie auch in sämtlichen anderen Figuren sind leitende Kupferflächen weiß und nicht-leitende Bereiche schwarz dargestellt. In Figur 5 handelt es sich nun um eine serielle Verschaltung, da die jeweiligen Finger 14 der einen Solarzelle mit der Rückseite der nächsten Solarzelle elektrisch leitend verbunden sind.

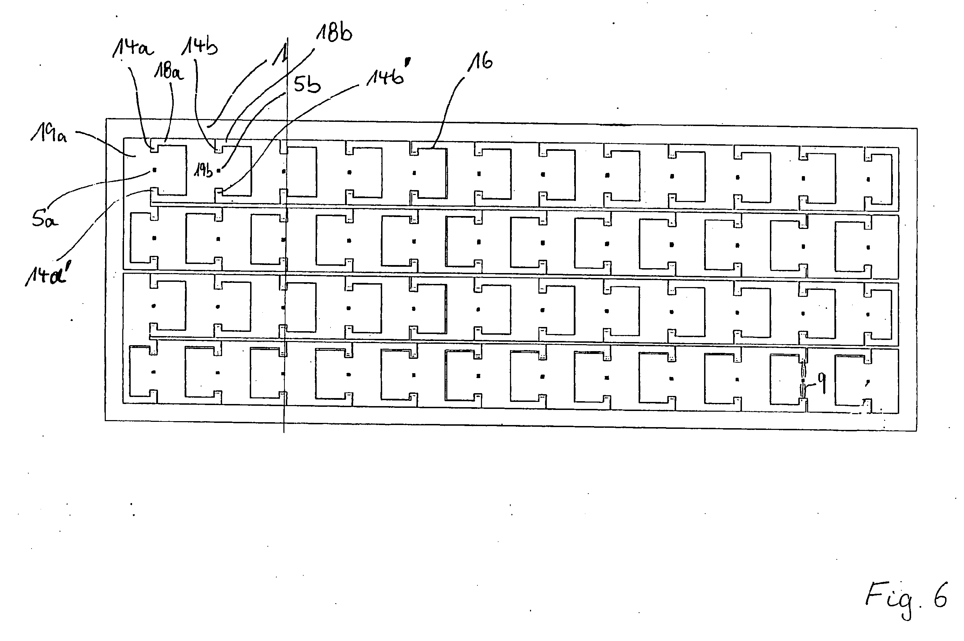

Auch Figur 6 zeigt eine weitere Ausführungsform einer seriellen Verschaltung innerhalb eines Solarzellenmoduls aus 4 mal 12 Solarzellen 5. Hierbei wurden jedoch lediglich die ersten Solarzellen mit Bezugszeichen versehen.

Es ist zu erkennen, dass wiederum die Finger 14 über die Fläche 18 mit der Fläche 19 der nachfolgenden Solarzelle und damit mit deren Pluspol verbunden sind. Die Finger 14 sind hier kürzer ausgeführt, so dass die in dieser Figur lediglich bei der zweitletzten Solarzelle eingezeichneten Bonddrähte länger sein müssen als in den Ausführungsformen der Figuren 4 und 5.

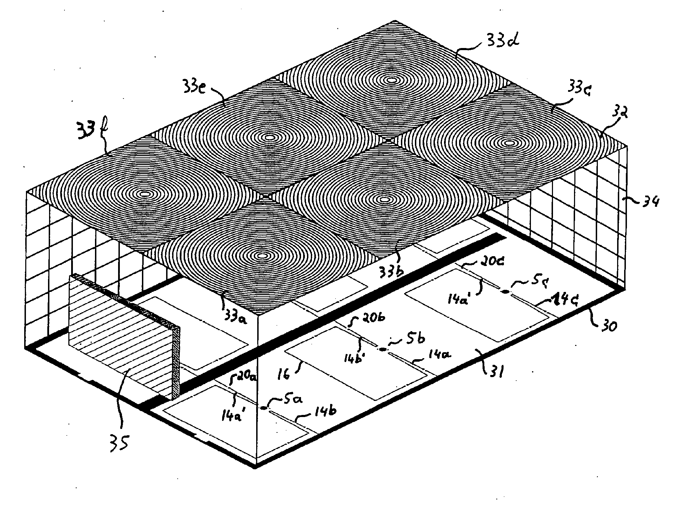

Figur 7 zeigt ein vollständiges Solarmodul mit Konzentratoroptik gemäß der vorliegenden Erfindung. Dieses Solarmodul weist ein Substrat 30 auf, auf dem eine Kupferfolie 31 angeordnet ist. Auf dieser Kupferfolie sind Solarzellen 5a, 5b, 5c etc. in serieller Verschaltung angeordnet. Der Aufbau und die Strukturierung der Kupferfolie entsprechen weitergehend denjenigen, wie er in Figur 5 gezeigt ist. Die auf dem Substrat 30 schwarz dargestellten Bereiche (mit Ausnahme der Solarzellen 5a, 5b, 5c etc.) sind nicht-leitende Bereiche, an denen keine Kupferfolie vorhanden ist. Die Kupferfolie 31 weist ihrerseits Gräben 16 auf, die sie so strukturieren, dass sich eine serielle Verschaltung beginnend mit der Solarzelle 5a über die Solarzelle 5b und 5c und die parallel dazu angeordneten, teilweise in der Zeichnung verdeckten Solarzellen ergibt.

Das Solarmodul weist weiterhin eine Abdeckung 32 auf, die insgesamt sechs Fresnel-Linsen 33a bis 33f aufweist, die nebeneinander derart angeordnet sind, dass die Brennpunkte dieser Fresnel-Linsen 33a bis 33f jeweils auf die Solarzellen 5a, 5b, 5c etc. fokussiert sind. Die Abdeckung 32 mit den Fresnel-Linsen 33a bis 33f ist einstückig ausgebildet und beispielsweise aus einem Kunststoff im Spritzgießverfahren hergestellt. Um das erfindungsgemäße Solarmodul herzustellen, ist es also lediglich erforderlich, die Abdeckung 32 relativ zu dem Substrat 30 richtig zu positionieren. Dies erfordert nur einen einzigen Positionierschritt. Die Abdeckung 32 ist über Wandungen 34 vom Substrat 30 beabstandet. Die Wandungen 34 dienen auch dazu, das Innere des Solarmoduls hermetisch abzuschließen, so dass dieses in seinem Inneren weder verschmutzen noch anderweitig beschädigt werden kann. Zusätzlich kann wie beim vorliegenden Beispiel eine Revisionsöffnung mit Abdeckung 35 in einer der Seitenwände vorgesehen werden.

Mit der vorliegenden Erfindung ist es damit erstmals möglich, großflächige Module für die Konzentrator-Photovoltaik kostengünstig und präzise zu fertigen.

## Patentansprüche

1. Solarzellenmodul für konzentrierende Solarsysteme mit einer Vielzahl von Solarzellen (5a, 5b, 5c), die in einer Ebene auf einem flächigen Substrat (30) angeordnet sind,
wobei die Solarzellen (5a, 5b, 5c) substratseitig einen ersten elektrischen Kontakt und auf der vom Substrat abgewandten Seite mindestens einen zweiten elektrischen Kontakt aufweisen,
wobei
das Substrat auf der den Solarzellen zugewandten Oberfläche flächig mit einer Metallschicht beschichtet ist, und
die Metallschicht aufweist:
a) eine Vielzahl von flächigen Abschnitten (12a, 12b, 12c), die jeweils einer Solarzelle zugeordnet sind,
wobei jeder Abschnitt der Metallschicht einen ersten (19a, 19b, 19c) und mindestens einen zweiten (18a, 18b, 18c) Bereich aufweist, die elektrisch voneinander isoliert sind und wobei der erste Bereich sich unter die zugeordnete Solarzelle erstreckt und den ersten Kontakt elektrisch leitend kontaktiert, und wobei der zweite Bereich mit dem zweiten Kontakt der Solarzelle elektrisch leitend verbunden ist, und wobei der zweite Bereich fingerförmig ausgebildet ist und der Finger (14a, 14b) radial zur Solarzelle hingeführt ist, sowie
b) Verbindungsabschnitte (21a, 21b) zwischen Bereichen benachbarter Abschnitte, wobei die Metallschicht mittels Gräben (16) zur Erzeugung der ersten und zweiten Bereiche strukturiert ist.

2. Solarzellenmodul nach dem vorhergehenden Anspruch, **dadurch gekennzeichnet, dass** die Gräben eine maximale Breite von < 1 mm, vorteilhafterweise < 0,5 mm, vorteilhafterweise < 0,1 mm aufweisen.

3. Solarzellenmodul nach einem der vorhergehenden Ansprüche, **dadurch gekennzeichnet, dass** die Verbindungsabschnitte Ausgleichsstrukturen (21a, 21b) zum Ausgleich von Materialspannungen zwischen dem Substrat und der Metallschicht aufweisen.

4. Solarzellenmodul nach einem der vorhergehenden Ansprüche, **dadurch gekennzeichnet, dass** die Verbindungsabschnitte zumindest teilweise zwischen den zu verbindenden Bereichen mäanderförmige oder verschachtelte T-Strukturen (21a, 21b) aufweisen.

5. Solarzellenmodul nach einem der vorhergehenden Ansprüche, **dadurch gekennzeichnet, dass** die Verbindungsabschnitte (21a, 21b) jeweils einen ersten Bereich eines Abschnittes mit jeweils einem ersten Bereich eines oder mehrerer benachbarter Abschnitte verbinden.

6. Solarzellenmodul nach einem der vorhergehenden Ansprüche, **dadurch gekennzeichnet, dass** die Verbindungsabschnitte jeweils einen ersten Bereich eines Abschnittes mit einem oder genau einem zweiten Abschnitt eines benachbarten Abschnitts verbinden.

7. Solarzellenmodul nach einem der vorhergehenden Ansprüche, **dadurch gekennzeichnet, dass** die Metallschicht die Oberfläche des Substrates zu > 50, vorteilhafterweise > 80 %, vorteilhafterweise > 90 %, vorteilhafterweise > 95% bedeckt.

8. Solarzellenmodul nach einem der vorhergehenden Ansprüche, **dadurch gekennzeichnet, dass** die Metallschicht das Substrat vollständig bedeckt, mit Ausnahme eines umlaufenden Randes des Substrates und/oder Gräben zur Strukturierung in der Metallschicht.

9. Solarzellenmodul nach einem der vorhergehenden Ansprüche, **dadurch gekennzeichnet, dass** die Metallschicht Kupfer, Aluminium und/oder eine Legierung hiervon enthält oder daraus besteht und/oder eine Kupferfolie ist.

10. Solarzellenmodul nach einem der vorhergehenden Ansprüche, **dadurch gekennzeichnet, dass** die Metallschicht eine Kupferfolie mit einer Dicke über 0,01 mm und/oder kleiner 3 mm, vorteilhafterweise über 35 µm und/oder kleiner 900 µm, vorteilhafterweise über 70 µm und/oder kleiner 500 µm, zumindest bereichsweise aufweist oder daraus besteht.

11. Solarzellenmodul nach einem der vorhergehenden Ansprüche, **dadurch gekennzeichnet, dass** die Metallschicht auf das Substrat laminiert ist.

12. Solarzellenmodul nach einem der vorhergehenden Ansprüche, **dadurch gekennzeichnet, dass** das Substrat zumindest bereichsweise aus Glas oder Glasfaserverbundwerkstoff ist.

13. Solarzellenmodul nach einem der vorhergehenden Ansprüche, **dadurch gekennzeichnet, dass** auf dem Substrat weitere elektrische Bauelemente und/oder Schutzdioden angeordnet sind.

14. Solarzellenmodul nach einem der vorhergehenden Ansprüche, **dadurch gekennzeichnet, dass** die Metallschicht elektrische Leitungsstrukturen, Datenleitungen und/oder Zu- und/oder Ableitungen zu weiteren auf dem Substrat (30) angeordneten elektrischen Bauelementen, aufweist.

15. Solarzellenmodul nach einem der vorhergehenden Ansprüche, **dadurch gekennzeichnet, dass** die Metallschicht Positioniermarken und/oder Stanzmarken (20a, 20b, 20c) aufweist.

16. Solarzellenmodul nach einem der vorhergehenden Ansprüche, **dadurch gekennzeichnet, dass** beabstandet von der Oberfläche des Substrates Lichtsammelvorrichtungen (33a bis 33f) derart angeordnet sind, dass in dem Brennpunkt jeder Lichtsammelvorrichtung eine Solarzelle (5a, 5b, 5c) angeordnet ist.

17. Solarzellenmodul nach dem vorhergehenden Anspruch, **dadurch gekennzeichnet, dass** die Lichtsammelvorrichtung eine Kollimatorlinse enthält.

18. Solarzellenmodul nach einem der beiden vorhergehenden Ansprüche, **dadurch gekennzeichnet, dass** die Lichtsammelvorrichtung eine Fresnellinse (33a bis 33f) enthält.

19. Solarzellenmodul nach einem der vorhergehenden Ansprüche, **dadurch gekennzeichnet, dass** der eine Solarzelle kontaktierende erste Bereich eine zusammenhängende Metallfläche bildet, die sich zu einer oder beiden Seiten der Solarzelle unter einem Öffnungswinkel von > 30°, vorteilhafterweise > 45°, vorteilhafterweise > 90°, vorteilhafterweise > 120° gesehen aus der Position der Solarzelle erstreckt.

20. Solarzellenmodul nach einem der vorhergehenden Ansprüche, **dadurch gekennzeichnet, dass** der zweite Bereich fingerförmig ausgebildet ist.

21. Solarzellenmodul nach dem vorhergehenden Anspruch, **dadurch gekennzeichnet, dass** der Finger sich unter einem Öffnungswinkel < 30°, vorteilhafterweise <10° gesehen aus der Position der Solarzelle erstreckt.

22. Solarzellenmodul nach einem der beiden vorhergehenden Ansprüche, **dadurch gekennzeichnet, dass** der Finger zumindest an seinem der Solarzelle zugewandten Ende oder auf einer Länge von mindestens 5 mm mindestens eine Breite von < 2 mm, vorteilhafterweise < 1 mm aufweist.

23. Verfahren zur Herstellung eines Solarzellenmoduls nach einem der vorhergehenden Ansprüche,
**dadurch gekennzeichnet,**
**dass** die Oberfläche des flächigen Substrats mit einer Metallschicht beschichtet wird,
wobei die Metallschicht vor oder nach der Beschichtung zur Ausbildung der Vielzahl flächiger Abschnitte und der Bereiche der Abschnitte strukturiert wird,
für jeden Abschnitt an vorbestimmten Stellen auf der Metallschicht eine Solarzelle mit ihrem ersten elektrischen Kontakt in elektrischem Kontakt mit der Metallschicht angeordnet wird und
für jeden Abschnitt der zweite Bereich mit dem zweiten elektrischen Kontakt der Solarzelle verbunden wird.

24. Verfahren nach dem vorhergehenden Anspruch, **dadurch gekennzeichnet, dass** zur Strukturierung der Metallschicht Gräben in der Kupferschicht erzeugt werden.

25. Verfahren nach einem der beiden vorhergehenden Ansprüche, **dadurch gekennzeichnet, dass** die Strukturierung der Metallschicht durch photolithographisches Ätzen, Stanzen und/oder Laserschneiden erfolgt.

26. Verfahren nach einem der Ansprüche 23 bis 25, **dadurch gekennzeichnet, dass** im Falle der Strukturierung der Metallschicht vor der Beschichtung der Oberfläche des Substrates mit der Metallschicht zwischen den einzelnen Bereichen oder Abschnitten an vorbestimmten Stellen Verbindungsstege aus Metall zwischen benachbarten Bereichen oder Abschnitten als Stanzmarkierungen erhalten werden und
diese Verbindungsstege nach dem Beschichten der Oberfläche des Substrates mit der Metallschicht durchtrennt werden.

27. Verfahren nach einem der Ansprüche 23 bis 26, **dadurch gekennzeichnet, dass** in die Metallschicht Positionsmarkierungen einstrukturiert werden und die Solarzellen und/oder weitere elektronische Bauelemente unter Berücksichtigung der Positionsmarkierungen positioniert werden.

28. Verwendung eines Solarzellenmoduls und eines Verfahrens nach einem der vorhergehenden Ansprüche in der Konzentratorphotovoltaik.

## Claims

1. Solar cell module for concentrating solar systems with a plurality of solar cells (5a, 5b, 5c) which are disposed in a plane on a two-dimensional substrate (30),
the solar cells (5a, 5b, 5c) having, on the substrate side, a first electrical contact and, on the side orientated away from the substrate, at least one second electrical contact, wherein
the substrate is coated on the surface orientated towards the solar cells two-dimensionally with a metal layer, and the metal layer has:
a) a plurality of two-dimensional portions (12a, 12b, 12c) which are assigned respectively to one solar cell,
each portion of the metal layer having a first (19a, 19b, 19c) and at least a second (18a, 18b, 18c) region which are electrically insulated from each other and the first region extending under the assigned solar cell and contacting the first contact in an electrically conductive manner, and
the second region being connected to the second contact of the solar cell in an electrically conductive manner, and
the second version having a finger-like configuration and the finger (14a, 14b) is guided radially to the solar cell, and
b) connecting portions (21a, 21b) between regions of adjacent portions, wherein
the metal layer is structured by means of grooves (16) in order to produce the first and second regions.

2. Solar cell module according to the preceding claim, **characterised in that** the grooves have a maximum width of < 1 mm, advantageously < 0.5 mm, advantageously < 0.1 mm.

3. Solar cell module according to one of the preceding claims, **characterised in that** the connecting portions have compensation structures (21a, 21b) for compensating for material stresses between the substrate and the metal layer.

4. Solar cell module according to one of the preceding claims, **characterised in that** the connecting portions have meandering or interleaved T-structures (21a, 21 b) at least partially between the regions to be connected.

5. Solar cell module according to one of the preceding claims, **characterised in that** the connecting portions (21a, 21b) respectively connect a first region of a portion to respectively a first region of one or more adjacent portions.

6. Solar cell module according to one of the preceding claims, **characterised in that** the connecting portions respectively connect a first region of a portion to one or precisely one second portion of an adjacent portion.

7. Solar cell module according to one of the preceding claims, **characterised in that** the metal layer covers the surface of the substrate up to > 50, advantageously > 80%, advantageously > 90%, advantageously > 95%.

8. Solar cell module according to one of the preceding claims, **characterised in that** the metal layer covers the substrate completely, with the exception of a circumferential edge of the substrate and/or grooves for structuring in the metal layer.

9. Solar cell module according to one of the preceding claims, **characterised in that** the metal layer comprises or consists of copper, aluminium and/or an alloy thereof and/or is a copper foil.

10. Solar cell module according to one of the preceding claims, **characterised in that** the metal layer comprises or consists of a copper foil with a thickness above 0.01 mm and/or less than 3 mm, advantageously above 35 µm and/or less than 900 µm, advantageously above 70 µm and/or less than 500 µm at least in regions.

11. Solar cell module according to one of the preceding claims, **characterised in that** the metal layer is laminated onto the substrate.

12. Solar cell module according to one of the preceding claims, **characterised in that** the substrate is made of glass or glass fibre composite material at least in regions.

13. Solar cell module according to one of the preceding claims, **characterised in that** further electrical components and/or protective diodes are disposed on the substrate.

14. Solar cell module according to one of the preceding claims, **characterised in that** the metal layer has electrical line structures, data lines and/or in and/or out lines to further electrical components disposed on the substrate (30).

15. Solar cell module according to one of the preceding claims, **characterised in that** the metal layer has positioning markings and/or punch marks (20a, 20b, 20c).

16. Solar cell module according to one of the preceding claims, **characterised in that** light collecting devices (33a to 33f), at a spacing from the surface of the substrate, are disposed in such a manner that a solar cell (5a, 5b, 5c) is disposed at the focal point of each light collecting device.

17. Solar cell module according to the preceding claim, **characterised in that** the light collecting device comprises a collimator lens.

18. Solar cell module according to one of the two preceding claims, **characterised in that** the light collecting device contains a Fresnel lens (33a to 33f).

19. Solar cell module according to one of the preceding claims, **characterised in that** the first region contacting a solar cell forms a continuous metal surface which extends on one or both sides of the solar cell at an opening angle of > 30°, advantageously > 45°, advantageously > 90°, advantageously > 120°, viewed from the position of the solar cell.

20. Solar cell module according to one of the preceding claims, **characterised in that** the second region has a finger-like configuration.

21. Solar cell module according to the preceding claim, **characterised in that** the finger extends at an opening angle < 30°, advantageously < 10°, viewed from the position of the solar cell.

22. Solar cell module according to one of the two preceding claims, **characterised in that** the finger has, at least on its end orientated towards the solar cell or on a length of at least 5 mm, at least a width of < 2 mm, advantageously < 1 mm.

23. Method for the production of a solar cell module according to one of the preceding claims,
***characterised in that***
the surface of the two-dimensional substrate is coated with a metal layer,
the metal layer being structured before or after the coating in order to form the plurality of two-dimensional portions and the regions of the portions,
a solar cell being disposed with its first electrical contact in electrical contact with the metal layer for each portion at predetermined positions on the metal layer and
the second region being connected to the second electrical contact of the solar cell for each portion.

24. Method according to the preceding claim, **characterised in that** grooves are produced in the copper layer for structuring the metal layer.

25. Method according to one of the two preceding claims, **characterised in that** the structuring of the metal layer is effected by photolithographic etching, punching and/or laser cutting.

26. Method according to one of the claims 23 to 25, **characterised in that**, in the case of structuring of the metal layer before coating the surface of the substrate with the metal layer between the individual regions or portions at predetermined positions, connecting webs made of metal are kept between adjacent regions or portions as punch markings and
these connecting webs are severed after coating of the surface of the substrate with the metal layer.

27. Method according to one of the claims 23 to 26, **characterised in that** position markings are structured into the metal layer and the solar cells and/or further electronic components are positioned taking into account the position markings.

28. Use of a solar cell module and of a method according to one of the preceding claims in concentrator photovoltaics.

## Revendications

1. Module de cellules solaires pour systèmes solaires à concentration avec une pluralité de cellules solaires (5a, 5b, 5c), qui sont agencées dans un plan sur un substrat plat (30),
dans lequel les cellules solaires (5a, 5b, 5c) présentent, côté substrat, un premier contact électrique et, sur le côté opposé au substrat, au moins un deuxième contact électrique, dans lequel
le substrat est revêtu à plat d'une couche de métal sur la surface tournée vers les cellules solaires, et la couche de métal présente :
a) une pluralité de sections plates (12a, 12b, 12c), qui sont respectivement affectées à une cellule solaire,
dans lequel chaque section de la couche de métal présente une première zone (19a, 19b, 19c) et au moins une deuxième zone (18a, 18b, 18c), qui sont isolées électriquement l'une de l'autre et dans lequel la première zone s'étend sous la cellule solaire affectée et touche le premier contact par voie électroconductrice, et dans lequel la deuxième zone est raccordée au deuxième contact de la cellule solaire par voie électroconductrice, et dans lequel la seconde zone a la forme d'un doigt et le doigt (14a, 14b) est guidé radialement jusqu'à la cellule solaire, et
b) des sections de raccordement (21a, 21 b) entre des zones de sections adjacentes, dans lequel la couche de métal est structurée au moyen de rigoles (16) pour générer les première et deuxième zones.

2. Module de cellules solaires selon la revendication précédente, **caractérisé en ce que** les rigoles présentent une largeur maximale < 1 mm, avantageusement < 0,5 mm, plus avantageusement < 0,1 mm.

3. Module de cellules solaires selon l'une quelconque des revendications précédentes, **caractérisé en ce que** les sections de raccordement présentent des structures de compensation (21a, 21 b) pour compenser des tensions de matériau entre le substrat et la couche de métal.

4. Module de cellules solaires selon l'une quelconque des revendications précédentes, **caractérisé en ce que** les sections de raccordement présentent des structures en T (21 a, 21 b) en méandres ou enchevêtrées, du moins partiellement entre les zones à raccorder.

5. Module de cellules solaires selon l'une quelconque des revendications précédentes, **caractérisé en ce que** les sections de raccordement (21a, 21b) raccordent respectivement une première zone d'une section à respectivement une première zone d'une ou plusieurs sections adjacentes.

6. Module de cellules solaires selon l'une quelconque des revendications précédentes, **caractérisé en ce que** les sections de raccordement raccordent respectivement une première zone d'une section à une ou précisément une deuxième zone d'une section adjacente.

7. Module de cellules solaires selon l'une quelconque des revendications précédentes, **caractérisé en ce que** la couche de métal couvre la surface du substrat sur plus de 50 %, avantageusement sur plus de 80 %, plus avantageusement sur plus de 90 %, encore plus avantageusement sur plus de 95 %.

8. Module de cellules solaires selon l'une quelconque des revendications précédentes, **caractérisé en ce que** la couche de métal couvre complètement le substrat, à l'exception d'un bord périphérique du substrat et/ou de rigoles pour la structuration dans la couche de métal.

9. Module de cellules solaires selon l'une quelconque des revendications précédentes, **caractérisé en ce que** la couche de métal contient du cuivre, de l'aluminium et/ou un alliage de ceux-ci ou en est constituée et/ou est une feuille de cuivre.

10. Module de cellules solaires selon l'une quelconque des revendications précédentes, **caractérisé en ce que** la couche de métal présente, au moins par zone, une feuille de cuivre d'une épaisseur supérieure à 0,01 mm et/ou inférieure à 3 mm, avantageusement supérieure à 35 µm et/ou inférieure à 900 µm, plus avantageusement supérieure à 70 µm et/ou inférieure à 500 µm, ou en est constituée.

11. Module de cellules solaires selon l'une quelconque des revendications précédentes, **caractérisé en ce que** la couche de métal est laminée sur le substrat.

12. Module de cellules solaires selon l'une quelconque des revendications précédentes, **caractérisé en ce que** le substrat est, au moins par zone, du verre ou un matériau composite de fibres de verre.

13. Module de cellules solaires selon l'une quelconque des revendications précédentes, **caractérisé en ce que** d'autres composants électriques et/ou des diodes de protection sont agencés sur le substrat.

14. Module de cellules solaires selon l'une quelconque des revendications précédentes, **caractérisé en ce que** la couche de métal présente des structures de conduction électrique, des lignes de données et/ou des amenées et/ou des dérivations vers d'autres composants électriques agencés sur le substrat (30).

15. Module de cellules solaires selon l'une quelconque des revendications précédentes, **caractérisé en ce que** la couche de métal présente des repères de positionnement et/ou des repères d'estampage (20a, 20b, 20c).

16. Module de cellules solaires selon l'une quelconque des revendications précédentes, **caractérisé en ce que** des dispositifs collecteurs de lumière (33a à 33f) sont agencés à distance de la surface du substrat de sorte qu'une cellule solaire (5a, 5b, 5c) est agencée dans le foyer de chaque dispositif collecteur de lumière.

17. Module de cellules solaires selon la revendication précédente, **caractérisé en ce que** le dispositif collecteur de lumière contient une lentille collimatrice.

18. Module de cellules solaires selon l'une quelconque des deux revendications précédentes, **caractérisé en ce que** le dispositif collecteur de lumière contient une lentille de Fresnel (33a à 33f).

19. Module de cellules solaires selon l'une quelconque des revendications précédentes, **caractérisé en ce que** la première zone en contact avec une cellule solaire forme une surface métallique continue, qui s'étend, observée depuis la position de la cellule solaire, vers l'un ou les deux côtés de la cellule solaire sous un angle d'ouverture > 30 °, avantageusement > 45 °, plus avantageusement > 90 °, encore plus avantageusement > 120 °.

20. Module de cellules solaires selon l'une quelconque des revendications précédentes, **caractérisé en ce que** la deuxième zone a la forme d'un doigt.

21. Module de cellules solaires selon la revendication précédente, **caractérisé en ce que** le doigt s'étend, observé depuis la position de la cellule solaire, sous un angle d'ouverture < 30 °, avantageusement < 10 °.

22. Module de cellules solaires selon l'une quelconque des deux revendications précédentes, **caractérisé en ce que** le doigt présente, au moins à son extrémité tournée vers la cellule solaire ou sur une longueur d'au moins 5 mm, au moins une largeur < 2 mm, avantageusement < 1 mm.

23. Procédé de fabrication d'un module de cellules solaires selon l'une quelconque des revendications précédentes, **caractérisé en ce que** la surface du substrat plat est revêtue d'une couche de métal,
dans lequel la couche de métal est structurée, avant ou après le revêtement, pour former la pluralité des sections plates et des zones des sections,
pour chaque section en des points prédéterminés sur la couche de métal, une cellule solaire est agencée avec son premier contact électrique en contact électrique avec la couche de métal et, pour chaque section, la deuxième zone est raccordée au deuxième contact électrique de la cellule solaire.

24. Procédé selon la revendication précédente, **caractérisé en ce que**, pour structurer la couche de métal, des rigoles sont ménagées dans la couche de cuivre.

25. Procédé selon l'une quelconque des deux revendications précédentes, **caractérisé en ce que** la structuration de la couche de métal s'effectue par gravure photolithographique, estampage et/ou découpe au laser.

26. Procédé selon l'une quelconque des revendications 23 à 25, **caractérisé en ce que**, dans le cas de la structuration de la couche de métal avant revêtement de la surface du substrat avec la couche de métal, on maintient entre les zones ou les sections individuelles, en des points prédéterminés, des barrettes de raccordement en métal entre des zones ou des sections adjacentes comme repères d'estampage, et
ces barrettes de raccordement sont sectionnées après revêtement de la surface du substrat avec la couche de métal.

27. Procédé selon l'une quelconque des revendications 23 à 26, **caractérisé en ce que** des repères de positionnement sont structurés à l'intérieur de la couche de métal et les cellules solaires et/ou d'autres composants électroniques sont positionnés en tenant compte des repères de positionnement.

28. Utilisation d'un module de cellules solaires et d'un procédé selon l'une quelconque des revendications précédentes dans le domaine du photovoltaïque à concentration.
